# EUROPEAN PATENT APPLICATION

(11) **EP 1 939 933 A2**
(43) Date of publication of application: **02.07.2008**
(21) Application number: 07124162.4
(22) Date of filing: 28.12.2007
(51) Int. Cl.: H01L 21/77

(54) **Thin film transistor, method of fabricating the same, and organic light emitting diode display device including the same**

(30) Priority: 28.12.2006 KR 20060136781
(71) Applicant: Samsung SDI Co., Ltd., Suwon-si Gyeonggi-do (KR)
(72) Inventor: Park, Byoung-Keon, Gyeonggi-do (KR); Yang, Tae-Hoon, Gyeonggi-do (KR); Seo, Jin-Wook, Gyeonggi-do (KR); Lee, Ki-Yong, Gyeonggi-do (KR)
(74) Representative: Hengelhaupt, Jürgen

(57) **Abstract**

Provided are a thin film transistor capable of enhancing electrical and leakage current characteristics by reducing an amount of crystallization inducing metal remaining in a semiconductor layer, a method of fabricating the same, and an organic light emitting diode display device including the same. The method of the thin film transistor of the present invention includes forming a first amorphous silicon layer (120) on a substrate (100), crystallizing the first amorphous silicon layer (120) into a first polycrystalline silicon layer (160) by using a crystallization inducing metal (140b), forming a second amorphous silicon layer (170) on the first polycrystalline silicon layer (160), implanting an impurity (175) into the second amorphous silicon layer (170), and annealing the first polycrystalline silicon layer (160) and the second amorphous silicon layer (170). The crystallization inducing metal (140b) in the first polycrystalline silicon layer (160) is transferred into the second amorphous silicon layer (170), and the second amorphous silicon layer (170) is crystallized into a second polycrystalline silicon layer.

## Description

### BACKGROUND OF THE INVENTION

### Field of the Invention

The present invention relates to a thin film transistor, a method of fabricating the same, and an organic lighting emitting diode display device (OLED display device) including the same, and more particularly, to a thin film transistor capable of enhancing an electrical characteristic of the thin film transistor and a leakage current characteristic by reducing an amount of crystallization inducing metal remaining in a semiconductor layer, a method of fabricating the same, and an OLED display device including the same.

### Description of the Related Art

In general, a polycrystalline silicon layer has high field effect mobility, can be applied to a high speed operating circuit, and facilitates to constitute a CMOS circuit so that it is widely used for forming a semiconductor layer of a thin film transistor. The thin film transistor using such a polycrystalline silicon layer is usually used for an active device of an active matrix liquid crystal display (AMLCD) and a switching device and a driving device of an OLED display device.

Methods of crystallizing amorphous silicon into polycrystalline silicon include a solid phase crystallization (SPC) method, an excimer laser annealing (ELA) method, a metal induced crystallization (MIC) method, a metal induced lateral crystallization (MILC) method, and so forth. In the SPC method, an amorphous silicon layer is annealed for several hours to tens of hours at temperature not greater than about 700°C, which is a deformation temperature of glass for forming a substrate of a display device using the thin film transistor. In the ELA method, an amorphous silicon layer is irradiated by an Excimer laser to locally apply heat for a very short time to induce crystallization. In the MIC method, a crystallization inducing metal such as nickel, palladium, gold, aluminum or the like is in contact with or is implanted into an amorphous silicon layer to induce a phase change from the amorphous silicon layer into a polycrystalline silicon layer due to the crystallization inducing metal. In the MILC method, silicide produced by reacting crystallization inducing metals with silicon is laterally and continuously grown to thereby sequentially induce crystallization of an amorphous silicon layer.

However, in the SPC method, it takes a too long process time and performs annealing for a long time at high temperature so that a substrate is apt to be deformed. The ELA method requires an expensive laser apparatus and has protrusions on a polycrystallized surface so that an interfacial characteristic between a semiconductor layer and a gate insulating layer is poor. The MIC method or the MILC method has disadvantages in that leakage current of a semiconductor layer of a thin film transistor increases because a large amount of crystallization inducing metal remains in a polycrystallized silicon layer.

Currently, much research is being carried out on the method of crystallizing the amorphous silicon layer using a crystallization inducing metal because the method has an advantage of performing crystallization in a short time at a lower temperature than the SPC method. The crystallization method using the crystallization inducing metal includes an MIC method and an MILC method. However, these methods using the crystallization inducing metal as a catalyst have device characteristics of the thin film transistor deteriorate due to contamination of the crystallization inducing metal.

To solve the contamination problem of the crystallization inducing metal, a method of fabricating a polycrystalline silicon layer is proposed as a crystallization method using a capping layer (See Korea Patent Publication No. 2003-0060403). The method deposits an amorphous silicon layer and a capping layer on a substrate, forms a crystallization inducing metal layer thereon, diffuses the crystallization inducing metal into the amorphous silicon layer through the capping layer by annealing or an annealing process using a laser beam to form a seed, and obtains a polycrystalline silicon layer using the same. This method has an advantage of preventing the metal from being contaminated more than required because the crystallization inducing metal is diffused through the capping layer, however, a large amount of crystallization inducing metal still remains in the polycrystalline silicon layer.

Accordingly, a gettering process is performed for removing the crystallization inducing metal after the amorphous silicon layer is crystallized using the crystallization inducing metal.

### SUMMARY OF THE INVENTION

The present invention provides a thin film transistor having a good electrical characteristic by gettering a crystallization inducing metal remaining in a semiconductor layer crystallized using the crystallization inducing metal, and reducing an amount of the crystallization inducing metal remaining in the semiconductor layer, a method of fabricating the same, and an OLED display device including the same.

According to another aspect of the present invention, a method of fabricating a thin film transistor comprises steps of providing a substrate, optionally forming a buffer layer on the substrate, forming a first amorphous silicon layer on the substrate or on the buffer layer, crystallizing the first amorphous silicon layer into a first polycrystalline silicon layer by using a crystallization inducing metal, forming a second amorphous silicon layer on the first polycrystalline silicon layer, implanting an impurity (dopant) into the second amorphous silicon layer, annealing the first polycrystalline silicon layer and the second amorphous silicon layer, such that the crystallization inducing metal in the first polycrystalline silicon layer is transferred into the second amorphous silicon layer, and the second amorphous silicon layer is crystallized into a second polycrystalline silicon layer, patterning the first polycrystalline silicon layer to form a first semiconductor layer, etching an opening in the second polycrystalline silicon layer to form a second semiconductor layer, such that a portion of the first semiconductor layer is exposed through the opening, forming a source electrode and a drain electrode to be connected to the first semiconductor layer and the second semiconductor layer, forming a gate insulating layer to cover the second semiconductor layer and the exposed portion of the first semiconductor layer, and forming a gate electrode on the gate insulating layer above the exposed portion of the first semiconductor layer through the opening.

Preferably, the step of crystallizing the first amorphous silicon layer includes using a method selected from the group consisting of metal induced crystallization (MIC), metal induced lateral crystallization (MILC), and super grained silicon (SGS). Peferably, the method of the SGS includes: forming a capping layer on the first amorphous silicon layer; forming a crystallization inducing metal layer on the capping layer, the crystallization inducing metal being included in the crystallization inducing metal layer; and annealing the crystallization inducing metal layer, the capping layer, and the first amorphous silicon layer.
Preferably, the capping layer is made of silicon nitride. Preferably, the capping layer has a thickness of 1 Å to 2000 Å.
Preferably, the crystallization inducing metal includes a metal selected from the group consisting of Ni, Pd, Ti, Ag, Au, Al, Sn, Sb, Cu, Co, Mo, Zr, Ru, Rh, Cd, and Pt. More preferably, the crystallization inducing metal is Ni.
Preferably, the impurity comprises phosphor (P) or boron (B). Preferably, the step of annealing the first polycrystalline silicon layer and the second amorphous silicon layer includes: heating the first polycrystalline silicon layer and the second amorphous silicon layer at temperature about 500°C to 993°C. Preferably, the step of the annealing the first polycrystalline silicon layer and the second amorphous silicon layer is performed for 30 seconds to 10 hours.

According to an aspect of the present invention, a thin film transistor comprises a substrate, a first semiconductor layer disposed on the substrate, a second semiconductor layer disposed on the first semiconductor layer where the second semiconductor layer has an opening exposing a portion of the first semiconductor layer, a source electrode and a drain electrode connected to the first semiconductor layer and the second semiconductor layer, a gate insulating layer disposed to cover the source and drain electrodes, and a gate electrode disposed on the gate insulating layer above the exposed portion of the first semiconductor layer through the opening. The second semiconductor layer includes a source semiconductor layer and a drain semiconductor layer. The opening is formed between the source semiconductor layer and the drain semiconductor layer, and a portion of the first semiconductor layer is exposed through the opening. The gate insulating layer also covers the opening.
The thin film transistor is produced according to the manufacturing method described above.
The second semiconductor layer of the thin film transistor may be implanted with an impurity (dopant). Preferably, the impurity comprises phosphor (P) or boron (B).
Each of the first and second semiconductor layers of the thin film transistor may include a crystallization inducing metal. Preferably, the crystallization inducing metal includes a material selected from the group consisting ofNi, Pd, Ti, Ag, Au, Al, Sn, Sb, Cu, Co, Mo, Zr, Ru, Rh, Cd, and Pt. More preferably, the crystallization inducing metal is Ni.
Preferably, the crystallization inducing metal included in the first semiconductor layer has a concentration less than 1x10¹⁵/cm³.
The non-exposed portion of the first semiconductor layer may form a source or a drain region. The exposed portion of the first semiconductor layer may form a channel region. According to still another aspect of the present invention, an organic lighting emitting diode display device (OLED display device) comprises a substrate, a first semiconductor layer disposed on the substrate, a second semiconductor layer disposed on the first semiconductor layer where the second semiconductor layer has an opening exposing a portion of the first semiconductor layer, a source electrode and a drain electrode connected to the first semiconductor layer and the second semiconductor layer, a gate insulating layer disposed to cover the source and drain electrodes, a gate electrode disposed on the gate insulating layer above the exposed portion of the first semiconductor layer through the opening, a first electrode connected to the source or drain electrode, a second electrode, and an organic layer disposed between the first electrode and the second electrode. The organic layer emits light. The second semiconductor layer includes a source semiconductor layer and a drain semiconductor layer. The opening is formed between the source semiconductor layer and the drain semiconductor layer, and a portion of the first semiconductor layer is exposed through the opening.

### BRIEF DESCRIPTION OF THE DRAWINGS

A more complete appreciation of the invention, and many of the attendant advantages thereof, will be readily apparent as the same becomes better understood by reference to the following detailed description when considered in conjunction with the accompanying drawings in which like reference symbols indicate the same or similar components, wherein:

FIGS. 1A to 1D are cross-sectional views illustrating a crystallization process according to an exemplary embodiment of the invention;

FIGS. 2A to 2E are cross-sectional views illustrating a process of fabricating a thin film transistor according to an exemplary embodiment of the present invention; and

FIG. 3 is a cross-sectional view of an OLED display device according to an exemplary embodiment of the present invention.

### DETAILED DESCRIPTION OF THE INVENTION

The present invention will now be described more fully hereinafter with reference to the accompanying drawings, in which exemplary embodiments of the invention are shown.

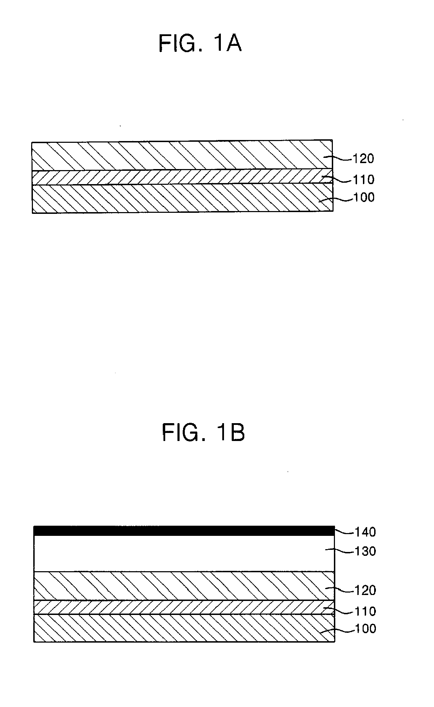

FIGS. 1A to 1D are cross-sectional views illustrating a crystallization process according to an exemplary embodiment of the present invention. A buffer layer 110 is formed on a substrate 100 such as glass or plastic as shown in FIG. 1A. The buffer layer 110 is formed of a single or double layer using an insulating layer such as a silicon oxide layer or a silicon nitride layer by a chemical vapor deposition (CVD) method or a physical vapor deposition (PVD) method. Here, the buffer layer 110 acts to prevent diffusion of moisture or impurities generated from the substrate 100 or acts to control a transfer rate of heat during crystallization, so that the crystallization of the amorphous silicon layer can be properly performed.

Subsequently, a first amorphous silicon layer 120 is formed on the buffer layer 110. Here, the first amorphous silicon layer 120 may be formed by CVD or PVD. Also, when or after the first amorphous silicon layer 120 is formed, a process of dehydrogenating the first amorphous silicon layer may be performed to reduce a hydrogen concentration.

Next, the first amorphous silicon layer 120 is crystallized into a first polycrystalline silicon layer. In the present invention, the first amorphous silicon layer 120 is crystallized into the first polycrystalline silicon layer by a crystallization method using a crystallization inducing metal such as an MIC method, an MILC method, or a super grained silicon (SGS) method.

In the MIC method, a crystallization inducing metal such as nickel (Ni), palladium (Pd), aluminum (Al) or the like is in contact with or is implanted into an amorphous silicon layer to induce a phase change from the amorphous silicon layer into a polycrystalline silicon layer due to the crystallization inducing metal. The MILC method makes silicide generated by reacting a crystallization inducing metal with silicon laterally and continuously grow, and thereby to sequentially induce crystallization from an amorphous silicon layer into a polycrystalline silicon layer.

Hereinafter, a method of forming a polycrystalline silicon layer using SGS according to an exemplary embodiment of the present invention will be described. FIG. 1B is a cross-sectional view illustrating a process of forming a capping layer and a crystallization inducing metal layer on the first amorphous silicon layer.

Referring to FIG. 1B, a capping layer 130 is formed on the first amorphous silicon layer 120. Here, the capping layer 130 is preferably formed of a silicon nitride layer which allows crystallization inducing metals to be formed in a subsequent process to be diffused through an annealing process, and may be formed of a double layer of a silicon nitride layer and a silicon oxide layer. The capping layer 130 is formed by a method such as CVD, PVD, or the like. Here, the capping layer 130 has a thickness of 1 Å to 2000 Å.

Subsequently, crystallization inducing metal is deposited on the capping layer 130 to form a crystallization inducing metal layer 140. Here, the crystallization inducing metal may be one selected from the group consisting of Ni, Pd, Ti, Ag, Au, Al, Sn, Sb, Cu, Co, Mo, Zr, Ru, Rh, Cd, and Pt, preferably Ni. Here, the crystallization inducing metal layer 140 is formed with a surface density of 10¹¹ atoms/cm² to 10¹⁵ atoms/cm² on the capping layer 130. Here, if the crystallization inducing metals have a surface density less than 10¹¹ atoms/cm², an amount of seed as a nucleus of crystallization is small so that it is difficult to crystallize the amorphous silicon layer into a polycrystalline silicon layer, and if the crystallization inducing metals have a surface density greater than 10¹⁵ atoms/cm ² an amount of crystallization inducing metal diffusing to the amorphous silicon layer is large so that crystal grains of the polycrystalline silicon layer are small, and an amount of remaining crystallization inducing metal is larger so that a characteristic of a semiconductor layer to be formed by patterning the polycrystalline silicon layer is deteriorated.

In general, the thickness of the crystallization inducing metal layer or density of the crystallization inducing metal should be carefully adjusted in the MIC or MILC method. This is because the crystallization inducing metals remain on a surface of the polycrystalline silicon layer after crystallization to cause a problem such as an increase in leakage current of the thin film transistor. However, the thick crystallization inducing metal layer may be formed without accurately controlling the thickness or density of the crystallization inducing metal layer in accordance with the present invention. This is because the capping layer 130 controls the diffusing crystallization inducing metals to cause only a small amount of crystallization inducing metal to be diffused into the amorphous silicon layer for contributing to crystallization and to cause most crystallization inducing metals not to penetrate the capping layer 130 for not contributing to crystallization.

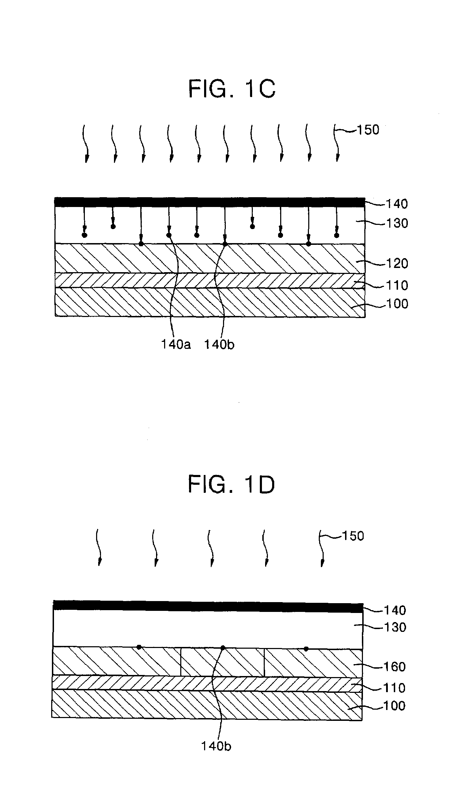

FIG. 1C is a cross-sectional view illustrating a process of annealing the substrate to diffuse the crystallization inducing metal to an interface of the first amorphous silicon layer through the capping layer. Referring to FIG. 1C, the substrate 100 where the buffer layer 110, the first amorphous silicon layer 120, the capping layer 130, and the crystallization inducing metal layer 140 are formed is subjected to an annealing process 150 to move some of the metals of the crystallization inducing metal layer 140 to a surface of the first amorphous silicon layer 120. That is, only a small amount of crystallization inducing metal 140b of the crystallization inducing metals 140a and 140b diffusing through the capping layer 130 due to the annealing process 150 are diffused to the surface of the first amorphous silicon layer 120, and most crystallization inducing metals 140a do not reach the amorphous silicon layer 120 or do not penetrate the capping layer 130.

Accordingly, an amount of crystallization inducing metals reaching the surface of the first amorphous silicon layer 120 is determined by the diffusion suppressing ability of the capping layer 130, and the diffusion suppressing ability of the capping layer 130 has close relations with the thickness of the capping layer 130. That is, as the thickness of the capping layer 130 is thick, the amount of the diffused crystallization inducing metal decreases so that the size of a crystal grain is larger, and as the thickness of the capping layer 130 is thin, the amount of the diffused crystallization inducing metal increases so that the size of the crystal grain is smaller.

Here, the annealing process 150 is performed for several seconds to several hours at a temperature of 200°C to 900°C to diffuse the crystallization inducing metals, and may include one process of a furnace process, a rapid thermal annealing (RTA) process, a UV process, and a laser process.

FIG. 1D is a cross-sectional view illustrating a process of crystallizing a first amorphous silicon layer into a first polycrystalline silicon layer due to diffused crystallization inducing metals. Referring to FIG. 1D, the first amorphous silicon layer 120 is crystallized into a first polycrystalline silicon layer 160 by the crystallization inducing metals 140b diffusing to the surface of the first amorphous silicon layer 120 through the capping layer 130. That is, the diffused crystallization inducing metals 140b are combined with silicon of the amorphous silicon layer to form metal silicide, and the metal silicide forms a seed as a nucleus of the crystallization so that the amorphous silicon layer is crystallized into the polycrystalline silicon layer.

Here, the crystallization method of the present invention includes forming a capping layer on an amorphous silicon layer, forming and annealing a metal catalyst layer on the capping layer, diffusing the metal catalyst, and crystallizing the amorphous silicon layer into a polycrystalline silicon layer using the diffused metal catalyst, which is referred to as an SGS crystallization method.

Therefore, an amount of the metal silicide as a nucleus of the crystallization, i.e., an amount of the crystallization inducing metal 140b can be adjusted so that the crystal grain size of the first polycrystalline silicon layer 160 can be adjusted.

Meanwhile, the annealing process 150 was performed without removing the capping layer 130 and the crystallization inducing metal layer 140 in FIG. 1D. However, it is also possible to diffuse the crystallization inducing metals onto the amorphous silicon layer to form metal silicide as a nucleus of the crystallization, remove the capping layer 130 and the crystallization inducing metal layer 140, and perform annealing thereon to form a polycrystalline silicon layer.

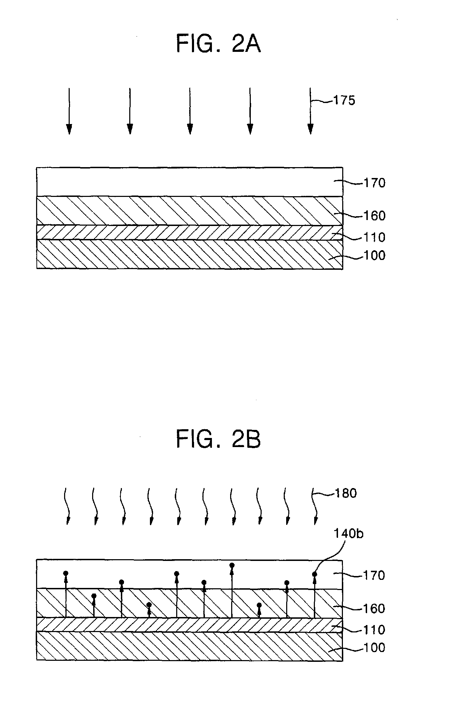

FIGS. 2A to 2E are cross-sectional views illustrating a process of fabricating a thin film transistor according to an exemplary embodiment of the present invention. Referring to FIG. 2A, after removing the capping layer 130 and the crystallization inducing metal layer 140, a second amorphous silicon layer 170 is formed on the first polycrystalline silicon layer 160. The second amorphous silicon layer 170 may be formed by CVD or PVD.

Subsequently, impurity ions 175 (dopant) are implanted into the second amorphous silicon layer 170. P-type impurity ions or n-type impurity ions may be used as the impurity ions 175 for forming a thin film transistor. Here the p-type impurity may be selected from the group consisting of boron (B), aluminum (Al), gallium (Ga), and indium (In), and the n-type impurity may be selected from the group consisting of phosphor (P), arsenic (As), and antimony (Sb).

Next, referring to FIG. 2B, an annealing process 180 is performed to remove crystallization inducing metals (e.g., Ni) remaining in the first polycrystalline silicon layer 160. The annealing process 180 is preferably performed at a temperature of 500°C to 993°C for 30 seconds to 10 hours. This is because diffusion of the crystallization inducing metals (e.g., Ni) of the first polycrystalline silicon layer 160 does not occur to make it difficult to remove the crystallization inducing metals when the annealing process 180 is performed at a temperature below 500°C, and nickel having a eutectic point of 993°C may exist in a solid state at a temperature smaller than 993°C and the substrate 100 may be deformed due to high temperature when the annealing process 180 is performed at a temperature higher than 993°C.

Also, the crystallization inducing metals (e.g., Ni) of the first polycrystalline silicon layer 160 cannot be sufficiently removed when the annealing process 180 is performed for a time less than 30 seconds, and deformation of the substrate 100 and production cost and yield problems of the thin film transistor may be caused due to the annealing for a long time when the annealing process 180 is performed for a time exceeding 10 hours.

Therefore, when the crystallization inducing metals 140b (e.g., Ni) remaining in the first polycrystalline silicon layer 160 are diffused to the region where the second amorphous silicon layer 170 is formed due to the annealing process 180, the crystallization inducing metals are precipitated so that they are not diffused any more. This is because the crystallization inducing metals (e.g., Ni) are in a more stable state in the amorphous silicon than in the polycrystalline silicon so that the crystallization inducing metals (e.g., Ni) in the polycrystalline silicon easily move to the amorphous silicon.

Here, the crystallization inducing metals (e.g., Ni) are diffused to the second amorphous silicon layer 170 by the annealing process 180 so that the second amorphous silicon layer 170 is crystallized into a second polycrystalline silicon layer by the crystallization inducing metals.

Therefore, the amount of crystallization inducing metals remaining in a channel region of the first semiconductor layer is less than 1×10¹⁵/cm³ by removing crystallization inducing metals remaining in the first polycrystalline silicon layer 160 which acts as the channel region of the first semiconductor layer, thereby forming a thin film transistor having a good electrical characteristic.

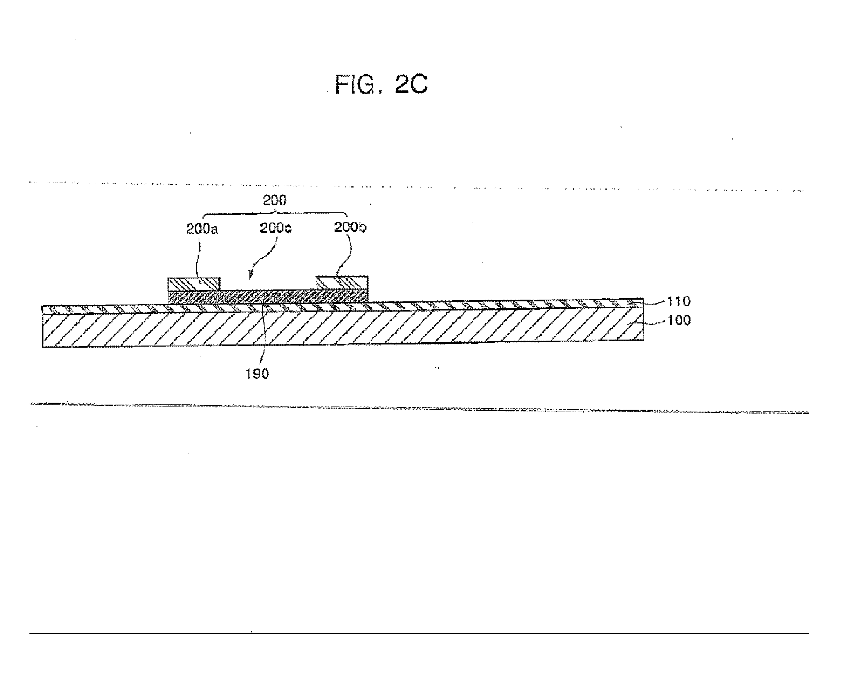

Referring to FIG. 2C, the first polycrystalline silicon layer 160 and the second polycrystalline silicon layer are patterned to form a first semiconductor layer 190 and a second semiconductor layer, respectively. The second semiconductor layer 200 has an opening 200c exposing a portion of the first semiconductor layer 190. The second semiconductor layer 200 includes a source semiconductor layer 200a and a drain semiconductor layer 200b. The opening 200c is between the source semiconductor layer 200a and the drain semiconductor layer 200b.
The second semiconductor layer includes a source semiconductor layer 200a and a drain semiconductor layer 200b.

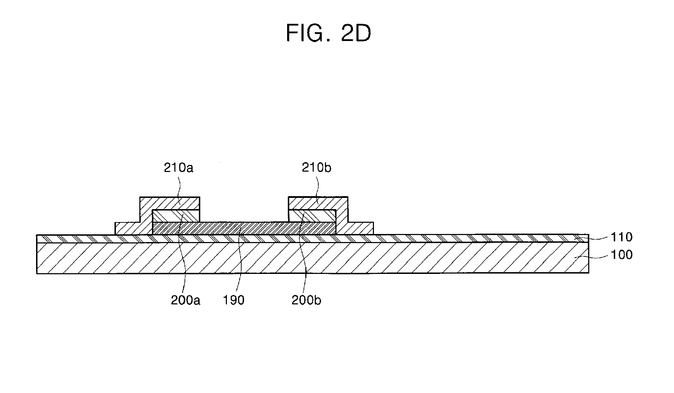

Referring to FIG. 2D, a material for source and drain electrodes is deposited on the entire surface of the substrate 100, and then patterned to form source and drain electrodes 210a and 210b. Accordingly, the source and drain electrodes 210a and 210b are electrically connected to the first semiconductor layer 190 and the second semiconductor layer 200. Specifically the source electrode 210a is connected to the source semiconductor layer 200a, and the drain electrode 210b is connected to the drain semiconductor layer 200b.

Here, the source and drain electrodes 210a and 210b may be formed of one selected from the group consisting of molybdenum (Mo), tungsten (W), molybdenum-tungsten (MoW), and aluminum (Al).

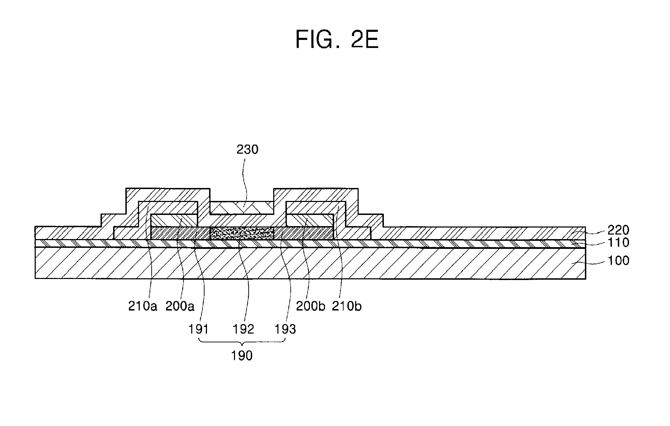

Referring to FIG. 2E, a gate insulating layer 220 is formed on the entire surface of the substrate 100 to insulate its lower structures. The gate insulating layer 220 may be formed of a silicon nitride layer, a silicon oxide layer, or a multiple layer thereof.

Subsequently, a gate electrode material is deposited on the entire surface of the substrate 100, and then patterned to form a gate electrode 230. The gate electrode 230 may be a single layer formed of Al or an aluminum alloy such as aluminum-neodymium (Al-Nd), or a multiple layer where an aluminum alloy is stacked on a Cr or Mo alloy. The gate electrode 230 is disposed on the gate insulating layer above the exposed portion of the first semiconductor layer. Accordingly, the source semiconductor layer 200a and a portion of the first semiconductor region 190 disposed below the source semiconductor layer 200a are a source region 191, and the drain semiconductor layer 200b and a portion of the first semiconductor region 190 disposed below the drain semiconductor layer 200b are a drain region 193. The exposed portion of the first semiconductor layer 190 below the gate electrode 230 can act as a channel region 192.

As described above, an amorphous silicon layer is formed on a polycrystalline silicon layer subjected to a crystallization process using a crystallization inducing metal to remove the crystallization inducing metal remaining in the polycrystalline silicon layer, so that a thin film transistor capable of enhancing a leakage current characteristic of a semiconductor layer and an electrical characteristic can be provided.

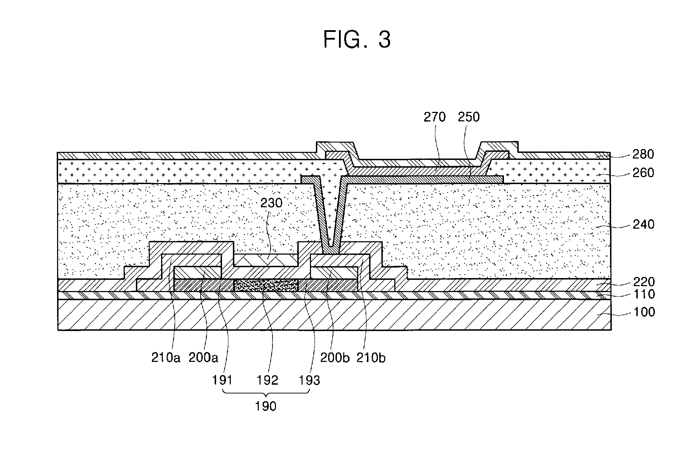

FIG. 3 is a cross-sectional view of an OLED display device according to an exemplary embodiment of the present invention. Referring to FIG. 3, a planarization layer 240 is formed on the entire surface of the substrate 100. The planarization layer 240 may be formed of an organic layer, an inorganic layer, or a composite layer thereof. The planarization layer 240 is preferably formed a Spin-On-Glass (SOG) when it is formed of an inorganic layer, and preferably formed of an acrylic resin, a polyimide resin, or benzocyclobutene (BCB) when it is formed of an organic layer.

In this case, the planarization layer 240 and the gate insulating layer 220 are etched to form a via hole exposing one of the source and drain electrodes 210a and 210b, and a first electrode 250 is formed to be connected to one of the source and drain electrodes 210a and 210b. The first electrode 250 is disposed on the bottom of the via hole, is in contact with one of the source and drain electrodes 210a and 210b, and extends onto the planarization layer 240. The first electrode 250 may be formed of Indium Tin Oxide (ITO) or Indium Zinc Oxide (IZO).

Subsequently, a pixel defining layer 260 is formed on the entire surface of the substrate 100 including the first electrode 250, wherein the pixel defining layer 260 has a thickness enough to sufficiently fill the via hole where the first electrode 250 is disposed. The pixel defining layer 260 may be formed of an organic layer or an inorganic layer, preferably an organic layer. More preferably, the pixel defining layer 260 is formed of one selected from the group consisting of benzocyclobutene (BCB), an acrylic polymer, and polyimide. The pixel defining layer 260 has good flowability so that it can be smoothly formed on the entire surface of the substrate.

In this case, the pixel defining layer 260 is etched to form an opening exposing the first electrode 250, and an organic layer 270 is formed on the first electrode 250 exposed through the opening. The organic layer 270 includes at least an emission layer, and may further include at least one of a hole injection layer, a hole transport layer, an electron transport layer, and an electron injection layer.

Subsequently, a second electrode 280 is formed on the entire surface of the substrate 100. The second electrode 280 may be formed of Mg, Ag, Al, Ca, and an alloy thereof which is transparent as a transmissive electrode and has a low work function. Accordingly, an OLED display device according to an exemplary embodiment of the present invention is completed.

In a semiconductor layer formed of a polycrystalline silicon layer which is crystallized using nickel as a crystallization inducing metal, an amorphous silicon layer is formed on the polycrystalline silicon layer and then subjected to annealing, and the nickel as the crystallization inducing metal is subjected to gettering, so that an amount of the crystallization inducing metal remaining in the polycrystalline silicon layer acting as a channel region of the semiconductor layer can be minimized and leakage current can be significantly reduced, thereby providing a thin film transistor having a good electrical characteristic and an OLED display device including the same.

According to the present invention as described above, a thin film transistor having good leakage current and electrical characteristics by removing a crystallization inducing metal remaining in a semiconductor layer, a method of fabricating the same, and an OLED display device including the same can be provided.

Although the present invention has been described with reference to certain exemplary embodiments thereof, it will be understood by those skilled in the art that a variety of modifications and variations may be made to the present invention without departing from the scope of the present invention defined in the appended claims, and their equivalents.

## Claims

1. A method of fabricating a thin film transistor, comprising the steps of:
providing a substrate (100);
optionally forming a buffer layer (110) on the substrate (100);
forming a first amorphous silicon layer (120) on the substrate (100) or on the buffer layer (110);
crystallizing the first amorphous silicon layer (120) into a first polycrystalline silicon layer (160) by using a crystallization inducing metal (140b);
forming a second amorphous silicon layer (170) on the first polycrystalline silicon layer (160);
implanting a dopant (175) into the second amorphous silicon layer (170);
annealing the first polycrystalline silicon layer (160) and the second amorphous silicon layer (170), such that the crystallization inducing metal (140b) in the first polycrystalline silicon layer (160) is transferred into the second amorphous silicon layer (170) and the second amorphous silicon layer (170) is crystallized into a second polycrystalline silicon layer;
patterning the first polycrystalline silicon layer (160) to form a first semiconductor layer (190);
etching an opening(200c) in the second polycrystalline silicon layer thereby forming a second semiconductor layer (200), such that a portion of the first semiconductor layer (190) is exposed through the opening(200c);
forming a source electrode (210a) and a drain electrode (210b) on the second semiconductor layer (200);
forming a gate insulating layer (220) to cover the source electrode (210a), the drain electrode (210b), and the exposed portion of the first semiconductor layer (190); and
forming a gate electrode (230) on the gate insulating layer (220) above the exposed portion of the first semiconductor layer (190).

2. The method according to claim 1, wherein the second semiconductor layer (200) includes a source semiconductor layer (200a) and a drain semiconductor layer (200b), and the opening (200c) is between the source semiconductor layer (200a) and the drain semiconductor layer (200b).

3. The method according to claim 1 or 2, wherein the step of crystallizing the first amorphous silicon layer (120) includes using a method selected from the group consisting of metal induced crystallization (MIC), metal induced lateral crystallization (MILC), and super grained silicon (SGS).

4. The method according to claim 3, wherein the method of the SGS includes:
forming a capping layer (130) on the first amorphous silicon layer (120);
forming a crystallization inducing metal layer (140) on the capping layer (130), the crystallization inducing metal (140a, 140b) being included in the crystallization inducing metal layer (140); and
annealing the crystallization inducing metal layer (140), the capping layer (130), and the first amorphous silicon layer (120).

5. The method according to claim 4, wherein the capping layer (130) is made of silicon nitride.

6. The method according to one of the preceding claims, wherein the crystallization inducing metal (140b) includes a metal selected from the group consisting of Ni, Pd, Ti, Ag, Au, Al, Sn, Sb, Cu, Co, Mo, Zr, Ru, Rh, Cd, and Pt.

7. The method according to one of the preceding claims, wherein the crystallization inducing metal (140b) consists ofNi.

8. The method according to one of the preceding claims, wherein the dopant (175) comprises phosphor (P) or boron (B).

9. The method according to one of the preceding claims, wherein the step of annealing the first polycrystalline silicon layer (160) and the second amorphous silicon layer (170) includes:
heating the first polycrystalline silicon layer (160) and the second amorphous silicon layer (170) at temperature in the range from 500°C to 993°C.

10. The method according to one of the preceding claims, wherein the step of the annealing the first polycrystalline silicon layer (160) and the second amorphous silicon layer (170) is performed for 30 seconds to 10 hours.

11. A thin film transistor produced by a method according to any one of claims 1-10.

12. The thin film transistor according to claim 11, wherein the second semiconductor layer (200) includes a dopant comprising phosphor (P) or boron (B).

13. The thin film transistor according to one of claims 11 and 12, wherein each of the first and second semiconductor layers includes a crystallization inducing metal (140b).

14. The thin film transistor according to claim 13, wherein the crystallization inducing metal (140b) includes a material selected from the group consisting of Ni, Pd, Ti, Ag, Au, Al, Sn, Sb, Cu, Co, Mo, Zr, Ru, Rh, Cd, and Pt.

15. The thin film transistor according to claim 14, wherein the crystallization inducing metal (140b) consists ofNi.

16. The thin film transistor according to one of claims 13-15, wherein the crystallization inducing metal (140b) included in the first semiconductor layer (190) has a concentration less than 1×10¹⁵/cm³.

17. An organic light emitting diode display device (OLED display device), comprising:
a thin film transistor according to one of claims 11-16;
a first electrode (250) connected to the source or drain electrode (210a, 210b);
a second electrode (280); and
an organic layer (270) for emitting light disposed between the first electrode (250) and the second electrode (280).
